# EUROPÄISCHE PATENTSCHRIFT

(11) **EP 2 263 431 B1**
(45) Veröffentlichungstag und Bekanntmachung des Hinweises auf die Patenterteilung: **20.12.2017**
(21) Anmeldenummer: 09716243.2
(22) Anmeldetag: 25.02.2009
(51) Int. Cl.: H05K 7/20, H01L 23/473

(54) **GEHÄUSE MIT KÜHLER FÜR LEISTUNGSELEKTRONIK**
HOUSING WITH A COOLING UNIT FOR POWER ELECTRONICS
BOÎTIER POURVU D UN ÉLÉMENT DE REFROIDISSEMENT POUR UN CIRCUIT ÉLECTRONIQUE DE PUISSANCE

(30) Priorität: 05.03.2008 DE 102008012645
(43) Veröffentlichungstag der Anmeldung: 22.12.2010
(73) Patentinhaber: Robert Bosch GmbH, 70442 Stuttgart (DE)
(72) Erfinder: SAUR, Dietmar, 72810 Gomaringen (DE)
(86) Internationale Anmeldenummer: PCT/EP2009/052181
(87) Internationale Veröffentlichungsnummer: WO 2009/109488

(56) Entgegenhaltungen:
- DE-A1- 2 945 149
- DE-A1- 19 734 054
- DE-A1-102006 019 691
- JP-A- 2006 286 767
- US-B1- 6 313 991
- M.G. COHEN, O. GUPTA, R.C. CHU: "Heat Transfer in a Liquid Cooling System. November 1968." IBM TECHNICAL DISCLOSURE BULLETIN, Bd. 11, Nr. 6, 1. November 1968 (1968-11-01), Seite 682, XP002527585 New York, US

## Beschreibung

### Stand der Technik

DE 100 15 046 C2 bezieht sich auf eine Schaltungsanordnung mit mindestens zwei Leiterplatten. Die mindestens zwei übereinander angeordneten Leiterplatten sind durch Kontakte elektrisch miteinander verbunden. Zwischen mindestens zwei der Leiterplatten ist eine Kanäle aufweisende Trägerplatte angeordnet. In einem Kanal der Trägerplatte ist genau ein Kontakt zugeordnet wobei jeweils ein Ende der Kanäle zum Einfädeln der Kontakte ausgebildet ist und das andere Ende der Kanäle zur exakten Positionierung der Kontakte ausgebildet ist und in der Trägerplatte Mittel zur elektromagnetischen Abschirmung angeordnet sind. In der Trägerplatte ist zudem eine Anordnung zur Kühlung elektronischer Bauteile der Schaltungsanordnung, bei denen es sich zum Beispiel um Leistungstransistoren handeln kann, integriert. Die Anordnung zur Kühlung kann beispielsweise durch einen in die Trägerplatte eingearbeiteten Kupferring mit Anschlüssen ausgebildet sein, der von Kühlwasser durchspült wird. Die Anschlüsse können in vorteilhafter Weise seitlich aus der Trägerplatte herausgeführt werden. Alternativ kann die Vorrichtung zur Kühlung als Miniaturlüfter ausgebildet sein, der entweder an der Schaltungsanordnung angeschlossen ist oder separat an eine Stromquelle angeschlossen werden kann.

DE 197 15 592 C2 bezieht sich auf eine Kühlvorrichtung für einen Elektronikbaustein. Diese Kühlvorrichtung umfasst ein dichtes, größtenteils metallisches Gehäuse für den Elektronikbaustein, was zumindest teilweise zur Kühlung von elektrischen Bauelementen im Elektronikbaustein herangezogen wird. Der Elektronikbaustein ist mit seinem Gehäuse in einem Kühlgehäuse untergebracht, wobei das Kühlgehäuse ein Zulaufanschluss an einem Ausströmkanal für eine Kühlflüssigkeit aufweist. Der Elektronikbaustein ist derart im Kühlgehäuse gelagert, dass bis auf die Lagerstellen und die Bereiche für Anschlussstecker des Elektronikbausteines von der Kühlflüssigkeit umströmbar ist. Teile des Kühlgehäuses können Baubestandteile einer Steuervorrichtung sein und bei der Kühlflüssigkeit kann es sich insbesondere um das Kühlwasser für den Motor des Kraftfahrzeuges handeln, welches direkt vom Kühler des Kraftfahrzeuges zum Kühlgehäuse geleitet wird.

Wird Kühlöl als Kühlflüssigkeit eingesetzt, kann dieses aus einem Getriebegehäuse eines Automatikgetriebes eines Kraftfahrzeuges zum Beispiel vom Ölkühler auf möglichst kurzem Weg direkt in ein Kühlgehäuse für mindestens einen Elektronikbaustein geleitet werden. Das Kühlgehäuse ist vorzugsweise aus Kunststoff hergestellt.

Des Weiteren kann an einem Gehäuseunterteil eine umlaufende Stufe ausgebildet sein, die als Lagerstelle für den Elektronikbaustein an einem umlaufenden Rand geeignet ist. Im Bereich des Gehäusedeckels ist ein Durchströmkühlkanal ausgebildet, welcher bis auf einen Anschlusssteckerbereich die ganze Fläche einer Grundplatte des Elektronikbausteines umfasst. Der Durchströmkühlkanal mündet in einen Ausströmkanal.

Bei einem weiteren Ausführungsbeispiel der Lösung gemäß DE 197 15 592 C2 ist ein Gehäuseunterteil wenige Millimeter unterhalb einer Stufe plan abgeschnitten. Zur Herstellung eines geschlossenen Kühlgehäuses wird diese Anordnung auf eine Platte eines Gehäuses so zum Beispiel für eine Getriebesteuerung aufgesetzt. Für die räumliche Aufnahme des Elektronikbausteines sowie für die richtige Durchströmung mit dem Kühlöl besitzt die Platte eine ausreichend große Vertiefung. In diese Vertiefung mündet eine Zulaufbohrung. Des Weiteren besitzt die Vertiefung einen Überströmkanal und die Platte nach Bedarf auch einen Ausströmkanal.

Die Offenlegungsschrift DE 10 2006 019 691 A1 zeigt beispielsweise in Fig. 2 ein externes Gehäuse einer Leistungswandlervorrichtung, in dem eine separate Kühleinrichtung zur Flüssigkühlung von mehreren Halbleitermodulen angeordnet ist. Die Kühleinrichtung besteht dabei aus einem Kühlmittelzufuhrkopf zum Zuführen eines Stroms flüssigen Kühlmittels, einer Mehrzahl von parallel angeordneten Kühlrohren sowie einem Kühlmittelabführkopf zum Auslassen des flüssigen Kühlmittels aus den Kühlohren.

Die Offenlegungsschrift JP 2006 286767 A zeigt und beschreibt eine Flüssigkühlung beispielsweise einer CPU eines Laptops, bei der die Kühleinrichtung in Form des Buchstabens S um die CPU-Bausteine herum gewunden sein kann.

Bei Kraftfahrzeugen mit Hybridantrieben werden Steuergeräte eingesetzt, die einen oder mehrere Leistungsbausteine zum Erzeugen elektrischer Drehstromfelder zum elektrischen Antriebes innerhalb des Hybridantriebstranges aufweisen. Wird der elektrische Antrieb im Generatormodus getrieben, werden die Leistungsbausteine zum Glätten des Drehstromes und somit zur Erzeugung eines Gleichstromes eingesetzt, der zum Beispiel zum Autladen der Kfz-Batterie genutzt werden kann.

Aufgrund der hohen Energie und der sich somit einstellenden Verlustleistung ist eine aktive Kühlung des oder der Leistungsbausteine notwendig.

### Offenbarung der Erfindung

Der vorliegenden Erfindung liegt die Aufgabe zugrunde, ein einfaches und robustes Steuergerät bereitzustellen, bei dem eine Kühlmittelführung außerhalb des Gehäuses erfolgt, welches hinsichtlich seines Gewichtes optimiert ist und durch bekannte und bewährte und kostengünstige Herstellverfahren hergestellt werden kann.

Erfindungsgemäß wird vorgeschlagen, ein Steuergerätegehäuse bzw. mindestens ein Gehäuseteil für ein Steuergerät aus Leichtmetall herzustellen, wobei die Kühlwasserführung an diesem mittels Kanälen dargestellt wird, die nur von der Außenseite des Gehäuses zugänglich sind. Innerhalb des Gehäuses sind die Leistungsbausteine stehend angeordnet und somit sehr hohlraumsparend aufgestellt. Je nach Erfordernissen, können im Steuergerätegehäuse eine größere oder kleinere Anzahl von in stehender Anordnung untergebrachte Leistungsbausteine verbaut werden. Dies eröffnet eine modulare Bauweise und eine kostengünstige Fertigung von Steuergerätegehäusen, so zum Beispiel für Hybridantriebe gemäß unterschiedlicher Anforderungsprofile.

Bei einem dreiphasig ausgebildeten System, werden pro Phase als Ansteuerungsphase für eine elektrische Maschine ein Modul oder mehrere Module eingesetzt. Die geringste Phasenzahl beträgt eins; derzeit werden zum Beispiel bei Hybridfahrzeugen drei oder neun Phasen eingesetzt.

Aufgrund der zu schaltenden Leistung wird jeweils die Unterseite der bevorzugt drei eingesetzten Module an einen Kühlkreislauf angeschlossen. Das erfindungsgemäß vorgeschlagene Steuergerätegehäuse wird bevorzugt aus Leichtmetall gefertigt, was Vorteile beim Einsatz an einem Kraftfahrzeug mit sich bringt nicht zuletzt hinsichtlich einer Gewichtsoptimierung. Wird das Steuergerätegehäuse aus Leichtmetall gefertigt, kann eine sehr gute Wärmleitfähigkeit erreicht werden, um die Verlustleistung, die der Leistungsbaustein bzw. die im Steuergerätegehäuse untergebrachte Anzahl von Leistungsbausteinen erzeugt, in Wärme umzuwandeln und abzuführen.

Der erfindungsgemäß vorgeschlagenen Lösung folgend, wird ein jeder der aufrecht stehend im Steuergerätegehäuse angeordneten Leistungsbausteine flächig vom Kühlmedium - sei es Kühlwasser, sei es Kühlöl - umspült, so dass ein guter Wärmeübergang von dem zu kühlenden Leistungsbaustein an das Kühlmedium erreicht werden kann.

Alternativ kann auch eine Kühlungsmöglichkeit eines Steuergerätegehäuses derart vorgesehen sein, was eine seitliche Vorbeiführung des Kühlmediums - sei es Kühlwasser, sei es Kühlöl - an einer Seitenwand des Steuergerätegehäuses erfolgen kann. In diesem Falle erfolgt die Kühlung über eine Wärmespreizung bzw. die Wärmeleitfähigkeit des Gehäusematerials, bei dem es sich bevorzugt um ein Leichtmetall handelt, welches per se ausgezeichnete Wärmeleiteigenschaften aufweist.

### Kurze Beschreibung der Zeichnungen

Anhand der Zeichnung wird die Erfindung nachstehend eingehender beschrieben.

Es zeigt:
- Figur 1: eine Ansicht des erfindungsgemäß vorgeschlagenen Steuergerätegehäuses mit integrierter Kühlbank für Leistungsbausteine und Darstellung des Strömungspfades des Weges des Kühlmediums,
- Figur 2: eine Ansicht des Steuergerätegehäuses gemäß der Darstellung in Figur 1 von der Unterseite her und
- Figur 3: das erfindungsgemäß vorgeschlagene Steuergerätegehäuse mit einem seitlich an diesem vorbeigeführten Strom eines Kühlmediums.

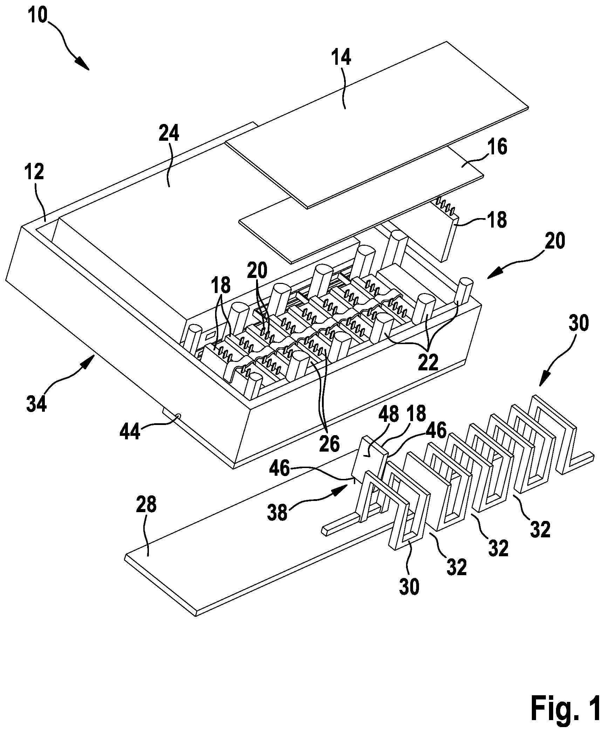

Der Darstellung gemäß Figur 1 ist eine perspektivische Ansicht des erfindungsgemäß vorgeschlagenen Steuergerätegehäuses mit integrierter Kühlung zu entnehmen.

Wie aus der perspektivischen Draufsicht gemäß Figur 1 entnehmbar, umfasst das Steuergerätegehäuse 10 - das hier geöffnet dargestellt ist - eine Gehäusewand 12, innerhalb ein Zwischenkreiskondensator 24 und eine Anzahl von Leistungsbausteinen 18 angeordnet sind. Das Steuergerätegehäuse 10 gemäß der perspektivischen Wiedergabe in Figur 1 umfasst eine Schaltungsplatine sowie ein Schaltungsträger 16. Über die Schaltungsplatine 14 wird die Anzahl der innerhalb des Steuergerätegehäuses 10 untergebrachten Leistungsbausteine 18 angesteuert. Die Leistungsbausteine 18 befinden sich in einer durch Bezugszeichen 38 angedeuteten stehenden Anordnung und sind in einzelnen Kühlbänken 26 innerhalb einer Rippenstruktur im Inneren des Steuergerätegehäuses 10 untergebracht. Die Kühlbänke 26 sind Bestandteil des Steuergerätegehäuses 10. An diesen Kühlbänken 26 werden die Leistungsbausteine 18 zum Beispiel durch Haltefedern oder dergleichen befestigt. Bevorzugt werden die Leistungsbausteine 18 derart angeordnet, dass sich diese in der durch Bezugszeichen 38 angedeuteten stehenden Anordnung flächig an die Kühlbänke 26 anschmiegen. Je größer der Kontakt der einander berührenden Flächen zwischen den Leistungsbausteinen 18, deren Wärme abzuführen ist, und den Kühlbänken 26 gestaltet werden kann, desto effizientere Wärmeabfuhr kann durch erfindungsgemäß vorgeschlagene Lösung im Steuergerätegehäuse 10 erreicht werden.

Die Kühlbänke 26, innerhalb derer die Leistungsbausteine 18 in stehender Anordnung 38 untergebracht sind, werden durch den in Figur 1 nach oben verschoben dargestellten Schaltungsträger 16 überdeckt. An einem jeden der Rippenstrukturen der Kühlbänke 26 für die Leistungsbausteine 18 befinden sich einander gegenüberliegend angeordnete Zapfen 22, auf welchen die Schaltungsplatine 14 oder Leiterplatte aufliegt und befestigt wird.

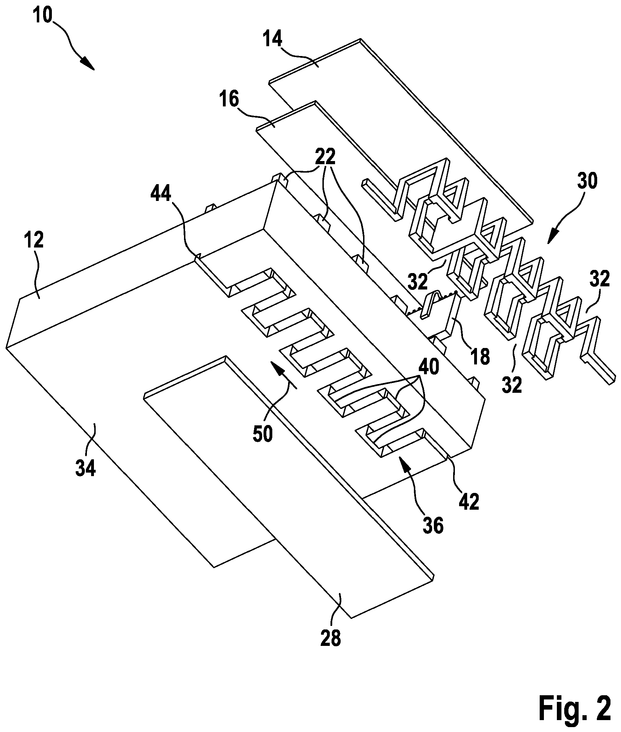

An ihrer Unterseite ist die Rippenstruktur, die die Kühlbänke 26 für die Leistungsbausteine 18 darstellt, durch eine Grundplatte 28 verschlossen. Die Grundplatte 28 ihrerseits überdeckt einen mäanderförmig verlaufenden Kühlkanal 36, dessen einzelne Mäander durch Bezugszeichen 40 angedeutet sind (vgl. perspektivische Ansicht von unten gemäß Figur 2).

Der Darstellung gemäß Figur 1 ist oberhalb der Grundplatte 28 ein in stehender Anordnung 38 dargestellter Leistungsbaustein 18 zu entnehmen. Der Leistungsbaustein 18 steht mit einer Aufstandsfläche 46 auf der Oberseite der Grundplatte 28 auf und wird entlang seiner Seitenflächen 48 entsprechend des Pfades 50 des Kühlmediums (vgl. Darstellung gemäß Figur 2) vom Kühlmedium, sei es Kühlwasser oder Kühlöl, umströmt. Mit Bezugzeichen 30 ist der Verlauf eines Kühlmittelstroms durch das Steuergerätegehäuse 10 bzw. dessen Kühlbänke 26 angedeutet. Aus der Darstellung gemäß Figur 1 geht hervor, dass der Verlauf 30 des Kühlmittelstromes durch das Steuergerätegehäuse 10 sowohl Abschnitte aufweist, die sich im Wesentlichen in horizontale Richtung erstrecken als auch Abschnitte aufweist, bei denen das Kühlmedium in Richtung eines Auslasses 44 in vertikale Richtung durchströmt. Der in Figur 1 perspektivisch dargestellte Verlauf 30 des Kühlmediums stellt den Verlauf des Kühlmediums dar, mit dem dieses die Kühlbänke 26 des Steuergerätegehäuses 10 durchströmt. An den einzelnen Seitenflächen der vom Kühlmedium gemäß des Verlaufes 30 durchströmten Kühlbänke 26, befinden sich bevorzugt in stehender Anordnung 38 die einzelnen Leistungsbausteine 18. Ein je größerer flächiger Kontakt zwischen diesen und den Seitenwänden der vom Kühlmedium durchströmten Kühlbänke 26 realisiert werden kann, eine desto bessere Wärmeabfuhr lässt sich durch die erfindungsgemäße Ausgestaltung des Steuergerätegehäuses 10 erzielen. Durch Zwischenräume 32 jeweils getrennten scharfkantigen oder rund ausgebildeten Übergänge der Abschnitte, die in horizontale Richtung verlaufen sowie sich die in vertikale Richtung erstreckenden Abschnitte des Verlaufes 30 des Kühlmediums, kann ein möglichst langer Strömungsweg des Kühlmediums durch die Kühlbänke 26 des Steuergerätegehäuses 10 erreicht werden, so dass durch die erfindungsgemäß vorgeschlagene Lösung selbst bei geringem Volumenstrom des Kühlmediums ein effektiver Abtransport der Abwärme der Leistungsbausteine 18 aus dem Steuergerätegehäuse 10 im Auslass 44 des Kühlkanales 36 (vgl. Darstellung gemäß Figur 2) erreicht werden kann.

Aus der Darstellung gemäß Figur 2, welche eine perspektivische Ansicht der Unterseite des Steuergerätegehäuses gemäß Figur 1 wiedergibt, ist zu entnehmen, dass das erfindungsgemäß vorgeschlagene Steuergerätegehäuse 10 einen ununterbrochenen Bodenflächenabschnitt 34 aufweist. Benachbart zu diesem verläuft innerhalb der ununterbrochenen Bodenfläche 34 des Steuergerätegehäuses 10 der Kühlkanal 36. Dieser weist eine Anzahl von Mäander 40 auf, die in der Darstellung gemäß Figur 2 eckig ausgebildet sind. Anstelle des in Figur 2 dargestellten, in eckiger Form ausgebildeten Mäanders 40, kann der Mäander 40 auch kurvenförmig, d.h. gerundet ausgebildet sein. Aus der Darstellung gemäß Figur 2 geht hervor, dass der im Bodenabschnitt 34 des erfindungsgemäß vorgeschlagenen Steuergerätegehäuses 10 ausgebildete Kühlkanal 36 durch die Grundplatte 28 verschlossen wird. Der die einzelnen, sei es in eckiger Form, sei es in abgerundeter Form ausgebildeten Mäander 40 aufweisende Kühlkanal 36 wird bei die Bodenfläche 34 eingelassener Grundplatte 28, die den Kühlkanal 36 überdeckt, eingangsseitig am Einlass 42 mit Kühlmedium beaufschlagt, welches das erfindungsgemäß vorgeschlagene Steuergerätegehäuse 10 am Auslass 44 wieder verlässt. Dabei wird der die einzelnen Mäander 40 aufweisende Kühlkanal 36 in Strömungsrichtung 50 entsprechend des Verlaufs 30 des Kühlmediums (vgl. Figur 1 Position 30) durchströmt.

Der Verlauf 30 des Kühlkanales 36 bzw. der sich daraus ergebende Strömungsweg 50 des Kühlmediums durch die Kühlbänke 26 des Steuergerätegehäuses 10be wirkt, dass eine Wärmeübertragung aufgrund von Wärmeleitung zwischen den bevorzugt in stehender Anordnung 38 zwischen den Kühlbänken 26 angeordneten Leistungsbausteinen 18 und den Seitenflächen der Kühlbänke 26 erreicht werden kann. Je größer die Kontaktfläche der einzelnen Leistungsbausteine 18 mit den Seitenflächen der Kühlbänke 26 gestaltet werden kann, desto größerer Wärmeübergang lässt sich erreichen. Besonders vorteilhaft bei der erfindungsgemäß vorgeschlagenen Ausgestaltung des Steuergerätegehäuses 10 mit den Einschüben für Leistungsbausteine 18 darstellenden Kühlbänken 26 ist darin zu erblicken, dass ein zwischen zwei Kühlbänke 26 eingeschobener Leistungsbaustein 18 beidseitig von Flächen kontaktiert wird, die ihrerseits - da Teil zweier Kühlbänke 26 - von Kühlmedium entsprechend des Verlaufs 30 gemäß des Strömungsweges 50 durchströmt werden. Dies bedeutet, dass die zwischen den einzelnen Kühlbänken 26 aufgenommenen Leistungsbausteine 18 gleichzeitig an beiden Seitenflächen - vorausgesetzt diese sind in stehender Anordnung 38 untergebracht - gekühlt werden.

Während der die einzelnen Mäander 40 aufweisende Kühlkanal 36 in der Bodenfläche 34 von der Grundplatte 28 überdeckt ist, werden die einzelnen in die Einschübe 26 gemäß Figur 2 in stehender Anordnung 38 eingeschobenen Leistungsbausteine 18 der Oberseite durch den Schaltungsträger 16 verschlossen, oberhalb der sich wiederum die Schaltungsplatine 14 befindet. Die einzelnen Leistungsbausteine 18 weisen - wie in Figur 1 erkennbar - einzelne Anschlusspins 20 auf, über welche die Ansteuerung der Leistungsbausteine 18 erfolgt.

Wie aus dem Muster von Mäandern 40 an der Bodenfläche 34 des Steuergerätegehäuses 10 hervorgeht, wird durch die in der in Figur 2 eckig verlaufenden Mäanderausführung erreicht, dass sowohl die vordere Seitenfläche 48 als auch die jeweils hintere Seitenfläche des in stehender Anordnung 38 in die Kühlbank 26 eingeschobenen Leistungsbaustein 18 beidseitig gekühlt wird. Dadurch ist eine effektive Wärmeabfuhr gewährleistet. Die Wärmeabfuhr kann einerseits durch die Taktfläche zwischen den Wänden der in stehender Anordnung 38 angeordneten Leistungsbausteine 18 und andererseits durch die Länge des Strömungsweges des Kühlmediums in einer Kühlbank 26 optimiert werden. So können beim Durchströmen des Kühlkanales 36 zwischen dem Einlass 42 des Kühlmediums in das Steuergerätegehäuses 10 und dessen Auslass 44 Temperaturdifferenzen von einigen Grad auftreten, um die das das Steuergerätegehäuse 10 verlassende Kühlmedium erwärmt ist. Je nach eingesetztem Kühlmedium bzw. erforderliche Abfuhr von Wärme von den Leistungsbausteinen 18 entsprechen deren Leistungsklasse, kann diese Temperaturerhöhung auch beträchtlich vom genannten Wert abweichen.

Der Darstellung gemäß Figur 2 ist zu entnehmen, dass der Strom des Kühlmediums am Eintritt 42 zunächst in der Horizontalen in den Kühlkanal 36, der sich in mehreren hintereinander geschalteten U-Bögen durch die Kühlbänke 26 erstreckt - im Steuergerätgehäuse 10 verläuft. Horizontale und vertikale Abschnitte des Kühlkanals 36 wechseln in alternierender Reihenfolge einander ab, so dass gewährleistet ist, dass eine möglichst große Fläche der in stehender Anordnung 38 zwischen den Kühlbänken 26 jeweils eingelassenen Leistungsbausteine 18 mit dem Kühlmedium überstrichen wird.

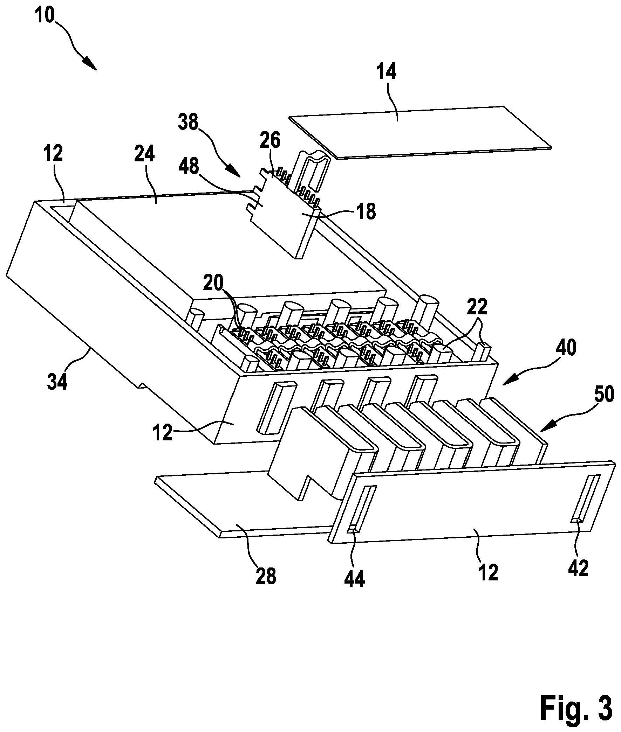

Der Darstellung gemäß Figur 3 ist eine alternative Ausführungsform des erfindungsgemäß vorgeschlagenen Steuergerätegehäuses 10 zu entnehmen. Wie Figur 3 zeigt, weist das Steuergerätegehäuse 10 gemäß dieser Ausführungsvariante ebenfalls die Gehäusewand 12 auf, die den Zwischenkreiskondensator 24 umschließt. Des Weiteren befinden sich innerhalb der Gehäusewand 12 des im Wesentlichen quadratisch ausgebildeten Steuergerätegehäuses 10 die Kühlbänke 26 zur Aufnahme der Leistungsbausteine 18 in stehender Anordnung 38, wie vorstehend bereits im Zusammenhang mit den Ausführungsformen gemäß der Figuren 1 und 2 beschrieben. Der Darstellung gemäß Figur 3 ist entnehmbar, dass die einzelnen Leistungsbausteine 18 in stehender Anordnung 38 in die Kühlbänke 26 eingeschoben sind, so dass die Seitenflächen 48 - Vorderseite und Rückseite der in stehender Anordnung 38 aufgenommenen Leistungsbausteine 18 - mit einer möglichst großen Oberfläche, die vom Kühlmedium gemäß dessen Strömungsweg 50 durchströmten Kühlbänke 26 kontaktieren.

Figur 3 zeigt, dass die Unterseite des Steuergerätegehäuses 10 von der Bodenfläche 34 begrenzt ist. In die Bodenfläche 34 kann die Grundplatte 28 eingelassen werden, die sich in der Darstellung gemäß Figur 3 seitlich neben der Gehäusewand 12 des Steuergerätegehäuses 10 befindet. Im Unterschied zu den in Figur 1 und 2 dargestellten Ausführungsformen des erfindungsgemäß vorgeschlagenen Steuergerätegehäuses, bei denen der Einlass 42 für das Kühlmedium bzw. dessen Auslass 44 an der Unterseite der Bodenfläche 34 ausgeführt sind, sind in der Seitenwand 12 gemäß der Ausführungsform des Steuergerätegehäuses 10 gemäß Figur 3 in der Gehäusewand 12 der Einlass 42 bzw. der Auslass 44 für das Kühlmedium angeordnet. Aufgrund der Konfiguration der Öffnungen am Einlass 42 bzw. am Auslass 44 für das Kühlmedium schlitzförmige, im Wesentlichen hochkant stehende Rechtecke ausgebildeten Öffnungen, ergibt sich ein breiterer Strömungspfad des Kühlmediums durch die Kühlbänke 36. Diese werden gemäß der in Figur 3 dargestellten Ausführungsform des erfindungsgemäß vorgeschlagenen Steuergerätegehäuses 10 nicht mehr von einem schmalen Verlauf des Kühlmediums, vgl. Verlauf 30 in Figuren 1 und 2, am Rand durchströmt, sondern vollflächig von der Innenseite her mit Kühlmedium benetzt.

Aufgrund der vollflächigen Benetzung der Seitenflächen der Kühlbänke 26 von der Innenseite her, stellt sich ein im Vergleich zu den in Figur 1 und 2 dargestellten Ausführungsvarianten nochmals verbesserter Wärmetransport ein. Wird berücksichtigt, dass die Kühlbänke 26 zwischen sich jeweils einen Leistungsbaustein 18 aufnehmen, wird der Leistungsbaustein 18 an beiden Seitenflächen 48 von den jeweiligen Seitenflächen der diesen kontaktierenden Kühlbänke 26 durchströmt. Da die Kühlbänke 26 gemäß der Ausführungsform in Figur 3 vollflächig von der Innenseite her mit Kühlmedium entsprechend des Strömungswegs 50 des Kühlmediums benetzt sind, lässt sich ein nochmals verbesserter Wärmeabtransport erzielen, was insbesondere bei höheren Leistungsklassen von Bedeutung ist.

## Patentansprüche

1. Steuergerätegehäuse (10, 12, 34) mit integrierter Kühlvorrichtung für mindestens einen Leistungsbaustein (18), wobei das Steuergerätegehäuse (10, 12, 34) aus einem metallischen Material gefertigt ist, einen Einlass (42) für ein Kühlmedium und einen Auslass (44) für das Kühlmedium aufweist und der mindestens eine Leistungsbaustein (18) von der Kühlflüssigkeit umströmbar ist, wobei der mindestens eine Leistungsbaustein (18) im Wesentlichen in stehender Anordnung (38) im Steuergerätegehäuse (10, 12, 34) untergebracht ist, in dem mindestens ein von der Außenseite zugänglicher Kühlkanal (36) verläuft, wobei der Kühlkanal (36) sich im Steuergerätegehäuse (10, 12, 34) durch Kühlbänke (26) für mindestens einen Leistungsbaustein (18) erstreckt, **dadurch gekennzeichnet, dass** die Kühlbänke (26) Bestandteil des Steuergerätegehäuses (10, 12, 34) sind, indem im Steuergerätegehäuse (10, 12, 34), insbesondere in einer Bodenfläche (34) desselben ein Mäander (40) aufweisender Kühlkanal (36) verläuft, und in ihrem Innenraum entsprechend eines Verlaufes (30, 50) von Kühlmedium durchströmt sind.

2. Steuergerätegehäuse (10, 12, 34) mit integrierter Kühlvorrichtung gemäß Anspruch 1, **dadurch gekennzeichnet, dass** die Kühlbänke (26) im Steuergerätegehäuse (12) derart angeordnet sind, dass zwischen jeweils zwei Kühlbänke (26) mindestens ein Leistungsbaustein (18) in stehender Anordnung (38) einschiebbar ist.

3. Steuergerätegehäuse (10, 12, 34) mit integrierter Kühlvorrichtung gemäß Anspruch 1, **dadurch gekennzeichnet, dass** der von der Außenseite zugängliche Kühlkanal (36) einen Einlass (42) sowie einen Auslass (44) aufweist, die entweder in einer Bodenfläche (34) des Steuergerätegehäuses (10) oder in einer Seitenwand (12) des Steuergerätegehäuses (12) untergebracht sind.

4. Steuergerätegehäuse (10, 12, 34) mit integrierter Kühlvorrichtung gemäß Anspruch 1, **dadurch gekennzeichnet, dass** der Kühlkanal (36) einen Verlauf (50) aufweist, der Zwischenräume (32) voneinander getrennte Mäander (40) aufweist, sowie horizontale Kanalabschnitte als auch sich in vertikale Richtung erstreckende Kanalabschnitte aufweist.

5. Steuergerätegehäuse (10, 12, 34) mit integrierter Kühlvorrichtung gemäß Anspruch 1, **dadurch gekennzeichnet, dass** der Kühlkanal (36) durch einen in der Gehäusewand (12) angeordneten Einlass (42) sowie einen in der Gehäusewand (12) angeordneten Auslass (44) mit Kühlmedium beaufschlagt ist und die Kühlbänke (26) flächig durchströmt.

6. Steuergerätegehäuse (10, 12, 34) mit integrierter Kühlvorrichtung gemäß einem oder mehrere der vorhergehenden Ansprüche, **dadurch gekennzeichnet, dass** mindestens ein zwischen die Seitenfläche zweier benachbarter Kühlbänke (26) eingeschobener Leistungsbaustein (18) beidseitig von den am Kühlmedium durchströmten Seitenflächen der Kühlbänke (26) kontaktiert ist.

7. Verwendung des Steuergerätegehäuses (10, 12, 34) mit integrierter Kühlvorrichtung gemäß einem oder mehrerer der Ansprüche 1 bis 6 für Leistungsbausteine (18), die an einer elektrischen Maschine, insbesondere im Hybridantrieb eines Kraftfahrzeuges angeordnet sind.

## Claims

1. Control device housing (10, 12, 34) with an integrated cooling apparatus for at least one power module (18), wherein the control device housing (10, 12, 34) is produced from a metallic material and has an inlet (42) for a cooling medium and an outlet (44) for the cooling medium and the cooling liquid can flow around the at least one power module (18), wherein the at least one power module (18) is accommodated with a substantially vertical arrangement (38) in the control device housing (10, 12, 34) in which at least one cooling channel (36) which is accessible from the outside runs, wherein the cooling channel (36) extends in the control device housing (10, 12, 34) through cooling banks (26) for at least one power module (18), **characterized in that** the cooling banks (26) are a constituent part of the control device housing (10, 12, 34) since a cooling channel (36) which has meanders (40) runs in the control device housing (10, 12, 34), in particular in a base surface (34) of the said control device housing, and cooling medium flows through the interior of the said cooling banks in accordance with a course (30, 50).

2. Control device housing (10, 12, 34) with an integrated cooling apparatus according to Claim 1, **characterized in that** the cooling banks (26) are arranged in the control device housing (12) in such a way that at least one power module (18) with a vertical arrangement (38) can be pushed between in each case two cooling banks (26).

3. Control device housing (10, 12, 34) with an integrated cooling apparatus according to Claim 1, **characterized in that** the cooling channel (36) which is accessible from the outside has an inlet (42) and an outlet (44), which inlet and outlet are accommodated either in a base surface (34) of the control device housing (10) or in a side wall (12) of the control device housing (12).

4. Control device housing (10, 12, 34) with an integrated cooling apparatus according to Claim 1, **characterized in that** the cooling channel (36) has a course (50) which has meanders (40) which are separated from one another by intermediate spaces (32), and has horizontal channel sections and also channel sections which extend in the vertical direction.

5. Control device housing (10, 12, 34) with an integrated cooling apparatus according to Claim 1, **characterized in that** the cooling channel (36) is acted on by cooling medium through an inlet (42) which is arranged in the housing wall (12) and an outlet (44) which is arranged in the housing wall (12), and flows in a two-dimensional manner through the cooling banks (26) .

6. Control device housing (10, 12, 34) with an integrated cooling apparatus according to one or more of the preceding claims, **characterized in that** at least one power module (18) which is pushed between the side surface of two adjacent cooling banks (26) is contacted on both sides by the side surfaces of the cooling banks (26) through which the cooling medium flows.

7. Use of the control device housing (10, 12, 34) with an integrated cooling apparatus according to one or more of Claims 1 to 6 for power modules (18) which are arranged on an electrical machine, in particular in the hybrid drive of a motor vehicle.

## Revendications

1. Boîtier d'appareil de commande (10, 12, 34) comportant un dispositif de refroidissement intégré destiné à au moins un composant de puissance (18), dans lequel le boîtier d'appareil de commande (10, 12, 34) est constitué d'un matériau métallique, comporte un orifice d'entrée (42) destiné à un agent réfrigérant et un orifice de sortie (44) destiné à l'agent de refroidissement et l'au moins un composant de puissance (18) peut être traversé par l'agent réfrigérant, dans lequel l'au moins un composant de puissance (18) est logé selon un agencement sensiblement vertical (38) dans le boîtier d'appareil de commande (10, 12, 34), qui est parcouru par au moins un canal de refroidissement (36) accessible de l'extérieur, dans lequel le canal de refroidissement (36) s'étend dans le boîtier d'appareil de commande (10, 12, 34) à travers des bancs de refroidissement (26) destinés à au moins un composant de puissance (18), **caractérisé en ce que** les bancs de refroidissement (26) font partie du boîtier d'appareil de commande (10, 12, 34) en ce sens qu'un canal de refroidissement (36) présentant un serpentin (40) parcourt le boîtier d'appareil de commande (10, 12, 34), notamment dans une surface inférieure (34) de celui-ci, et **en ce qu'**ils sont traversés dans leur espace intérieur par un agent réfrigérant en correspondance avec un parcours (30, 50) .

2. Boîtier d'appareil de commande (10, 12, 34) comportant un dispositif de refroidissement intégré selon la revendication 1, **caractérisé en ce que** les bancs de refroidissement (26) sont agencés dans le boîtier d'appareil de commande (12) de manière à ce qu'au moins un composant de puissance (18) puisse être inséré selon un agencement vertical (38) entre deux bancs de refroidissement (26) respectifs.

3. Boîtier d'appareil de commande (10, 12, 34) comportant un dispositif de refroidissement intégré selon la revendication 1, **caractérisé en ce que** le canal de refroidissement (36) accessible de l'extérieur comporte un orifice d'entrée (42) ainsi qu'un orifice de sortie (44) qui sont logés soit dans une surface inférieure (34) du boîtier d'appareil de commande (10) soit dans une paroi latérale (12) du boîtier d'appareil de commande (12).

4. Boîtier d'appareil de commande (10, 12, 34) comportant un dispositif de refroidissement intégré selon la revendication 1, **caractérisé en ce que** le canal de refroidissement (36) présente un parcours (50) qui comporte des serpentins (40) séparés les uns des autres par des espaces intermédiaires (32), et comportant également des sections de canal horizontales ainsi que des sections de canal s'étendant en direction verticale.

5. Boîtier d'appareil de commande (10, 12, 34) comportant un dispositif de refroidissement intégré selon la revendication 1, **caractérisé en ce que** le canal de refroidissement (36) est exposé à un agent de refroidissement au travers d'un orifice d'entrée (42) disposé dans la paroi de boîtier (12) et au travers d'un orifice de sortie (44) disposé dans la paroi de boîtier (12) et **en ce qu'**il traverse de manière plane les bancs de refroidissement (26).

6. Boîtier d'appareil de commande (10, 12, 34) comportant un dispositif de refroidissement intégré selon l'une ou plusieurs des revendications précédentes, **caractérisé en ce qu'**au moins un composant de puissance (18) inséré entre les surfaces latérales de deux bancs de refroidissement (26) voisins est mis en contact des deux côtés avec les surfaces latérales des bancs de refroidissement (26) traversées par l'agent réfrigérant.

7. Utilisation du boîtier d'appareil de commande (10, 12, 34) comportant un dispositif de refroidissement intégré selon l'une ou plusieurs des revendications 1 à 6 pour des composants de puissance (18) qui sont disposés sur une machine électrique, notamment dans un système de propulsion hybride d'un véhicule automobile.
